# EUROPÄISCHE PATENTSCHRIFT

(11) **EP 2 486 606 B1**
(45) Veröffentlichungstag und Bekanntmachung des Hinweises auf die Patenterteilung: **18.02.2015**
(21) Anmeldenummer: 10755122.8
(22) Anmeldetag: 01.09.2010
(51) Int. Cl.: H01L 35/06, H01L 35/32

(54) **MODUL MIT MEHREREN THERMOELEKTRISCHEN ELEMENTEN**
MODULE COMPRISING A PLURALITY OF THERMOELECTRIC ELEMENTS
MODULE AVEC PLUSIEURS ÉLÉMENTS THERMOÉLECTRIQUES

(30) Priorität: 09.10.2009 DE 102009048985
(43) Veröffentlichungstag der Anmeldung: 15.08.2012
(73) Patentinhaber: O-Flexx Technologies GmbH, 47059 Duisburg (DE)
(72) Erfinder: SPAN, Gerhard, A-6112 Wattens (AT)
(74) Vertreter: Kohlmann, Kai
(86) Internationale Anmeldenummer: PCT/EP2010/062798
(87) Internationale Veröffentlichungsnummer: WO 2011/042263

(56) Entgegenhaltungen:
- EP-B1- 1 287 566
- FR-A- 1 410 413
- FR-A- 1 476 756
- FR-A1- 2 427 690
- JP-A- 2008 010 764
- JP-A- 2008 288 535
- US-A- 3 714 539
- US-A- 4 497 973

## Beschreibung

Die Erfindung betrifft ein Modul umfassend mehrere elektrisch verbundene thermoelektrische Elemente, die zwischen einer ersten und einer zweiten Platte angeordnet sind, wobei ein Temperaturgradient zwischen einer heißen und einer kalten Seite jedes thermoelektrischen Elementes anlegbar bzw. abgreifbar ist und die thermoelektrischen Elemente an ihrer heißen Seite an der ersten Platte und an ihrer kalten Seite an der zweiten Platte anliegen.

Insbesondere betrifft die Erfindung ein Modul dessen thermoelektrische Elemente aus mindestens einer n-Schicht und mindestens einer p-Schicht aus thermoelektrischem Material unter Ausbildung wenigstens eines sich entlang einer Grenzschicht ausbildenden pn-Übergangs bestehen, wobei der Temperaturgradient parallel zur Grenzschicht zwischen einer heißen und einer kalten Seite jedes thermoelektrischen Elementes anlegbar bzw. abgreifbar ist. Außerdem betrifft die Erfindung ein Verfahren zur Herstellung eines derartigen Moduls.

Die Wirkungsweise thermoelektrischer Elemente beruht auf dem thermoelektrischen Effekt.

Beim Seebeck-Effekt entsteht zwischen zwei Punkten eines elektrischen Leiters bzw. Halbleiters, die eine verschiedene Temperatur haben, eine elektrische Spannung. Während der Seebeck-Effekt das Entstehen einer Spannung beschreibt, tritt der Peltier-Effekt ausschließlich durch das Fließen eines äußeren Stromes auf. In einem stromdurchflossenen Thermopaar treten immer beide Effekte auf. Der Peltier-Effekt tritt auf, wenn zwei Leiter oder Halbleiter mit unterschiedlichen elektronischen Wärmekapazitäten in Kontakt gebracht werden und durch einen von außen angelegten elektrischen Strom Elektronen aus dem einen Leiter / Halbleiter in den anderen fließen. Mit geeigneten Materialien, insbesondere HalbleiterMaterialien gelingt es, mit elektrischem Strom Temperaturdifferenzen zu erzeugen oder umgekehrt aus Temperaturdifferenzen elektrischen Strom zu erzeugen.

Die direkte Wandlung von Wärme in elektrische Energie ist mit einem thermoelektrischen Generator mit mehreren thermoelektrischen Elementen möglich. Die thermoelektrischen Elemente bestehen vorzugsweise aus unterschiedlich dotierten Halbleitermaterialien, wodurch sich die Effizienz gegenüber Thermoelementen mit zwei unterschiedlichen und an einem Ende miteinander verbundenen Metallen, wesentlich steigern lässt. Gebräuchliche Halbleitermaterialien sind Bi2Te3, PbTe, SiGe, BiSb oder FeSi2. Um ausreichend hohe Spannungen zu erhalten, werden mehrere thermoelektrische Elemente zu einem Modul zusammengefasst und elektrisch in Reihe und ggf. auch parallel geschaltet.

Um den Wirkungsgrad eines thermoelektrischen Generators zu steigern, wird in der EP 1 287 566 B1, ein gattungsgemäßes Modul umfassend mehrere elektrisch in Serie geschaltete thermoelektrische Elemente beschrieben. Die einzelnen thermoelektrischen Elemente bestehen jeweils aus mindestens einer n-Schicht und mindestens einer p-Schicht aus thermoelektrischem Material unter Ausbildung wenigstens eines sich entlang einer Grenzschicht ausbildenden pn-Übergangs. Parallel zur Grenzschicht zwischen den n- und p-Schichten ist ein Temperaturgradient angelegt. Der pn-Übergang ist im Wesentlichen entlang der gesamten, vorzugsweise längsten Ausdehnung der n-Schicht und der p-Schicht und damit im Wesentlichen entlang deren gesamter Grenzschicht ausgebildet. Durch den Temperaturgradienten entlang der großflächigen pn-Grenzfläche entsteht ein Temperaturunterschied entlang dieses länglich ausgebildeten pn-Übergangs zwischen zwei Enden eines pn-Schichtpakets, der dazu führt, dass der Wirkungsgrad des thermoelektrischen Elementes höher ist als beim Stand der Technik, der keinen Temperaturgradienten entlang und innerhalb des pn-Übergangs aufweist. Die thermoelektrischen Elemente sind zwischen zwei Platten thermisch parallel angeordnet. Die Platten dienen der verbesserten thermischen Ankopplung sowohl auf der kalten als auch heißen Seite. Sie sind vorzugsweise als gute Wärmeleiter ausgebildet, die vorzugsweise aus keramischen, elektrisch nicht leitenden Werkstoffen bestehen.

Die Höhe der von den thermoelektrischen Elementen erzeugten Thermospannung hängt unter anderem von der Temperaturdifferenz zwischen kalter und heißer Seite ab. Bei hohen Temperaturen und großen Temperaturdifferenzen stellen unterschiedliche Wärmeausdehnungs-Koeffizienten der in dem Modul zum Einsatz gelangenden Materialien an den Verbindungsstellen jedoch ein Problem dar. Des weiteren ist die Ankopplung der thermoelektrischen Elemente an die erste und zweite Platte problematisch.

Die FR 1 410 413 A offenbart ein Modul umfassend mehrere elektrisch verbundene thermoelektrische Elemente, die zwischen einer ersten Platte und einer zweiten Platte angeordnet sind, wobei ein Temperaturgradient zwischen einer heißen und einer kalten Seite jedes thermoelektrischen Elementes anlegbar ist. Die Schenkel der thermoelektrischen Elemente (P,N) liegen an ihrer heißen Seite nicht unmittelbar an der ersten Platte und an der kalten Seite nicht unmittelbar an der zweiten Platte an. Dazwischen befinden sich jeweils blockförmige Abstützungen. Die thermoelektrischen Schenkel (P, N) sind kraftschlüssig mit der ersten Platte und der zweiten Platte mit Hilfe von Federklemmen verbunden. Die Federklemmen bestehen aus elektrisch leitendem Material und stellen den Kontakt zwischen den P- und N-Schenkeln der thermoelektrischen Elemente abwechselnd auf der heißen und kalten Seite her.

Die JP 2008 288535 A offenbart ein thermoelektrisches Modul umfassend mehrere elektrisch verbundene thermoelektrische Elemente die zwischen einer ersten Platte und einer zweiten Platte angeordnet sind, wobei ein Temperaturgradient zwischen einer heißen und einer kalten Seite anlegbar ist. Die thermoelektrischen Elemente liegen an ihrer heißen Seite an der ersten Platte und an ihrer kalten Seite an der zweiten Platte an. Jeweils an dem N- bzw. P-Schenkel eines thermoelektrischen Elementes ist jeweils an einer Kerbe eine Elektrode angeklebt. Jeweils gegenüberliegende Elektroden an benachbarten thermoelektrischen Elementen werden durch eine Feder auf Abstand gehalten, wodurch ungleichmäßige Lastzustände in der Wärme aufnehmenden Platte und der Wärme abgebenden Platte ausgeglichen werden. Die erste und zweite Platte bilden zusammen mit Wandabschnitten ein Gehäuse aus, in dem die thermoelektrischen Elemente gleitend zwischen den Platten geführt sind.

Ausgehend von diesem Stand der Technik liegt der Erfindung die Aufgabe zu Grunde, ein Modul der eingangs erwähnten Art zu schaffen, das einen Betrieb mit hohen Temperaturen bzw. großen Temperaturdifferenzen zwischen heißer und kalter Seite zulässt und zugleich eine gute thermische Ankopplung auf der heißen Seite gewährleistet.

Die Lösung basiert auf dem Gedanken, trotz unterschiedlicher Ausdehnung der Platten thermomechanische Spannungen an den Übergängen der Platten zu den thermoelektrischen Elementen zu vermeiden bzw. zu reduzieren und zugleich eine gute thermische Ankopplung zu gewährleisten.

Im Einzelnen wird die Aufgabe bei einem Modul der eingangs erwähnten Art dadurch gelöst, dass die thermoelektrischen Elemente an ihrer kalten Seite kraftschlüssig mit der zweiten Platte verbunden sind und die thermoelektrischen Elemente an ihrer heißen Seite stoffschlüssig mit der ersten Platte verbunden sind.

Die kraftschlüssige Verbindung der thermoelektrischen Elemente zumindest mit der zweiten Platte, hat zur Folge, dass der Zusammenhalt zwischen dem thermoelektrischen Element und der Platte durch Haftkraft tangential zu den beteiligten Flächen gewährleistet wird. Die unterschiedliche Wärmeausdehnung zwischen der ersten und zweiten Platte führt lediglich zu einer Änderung der Haftkraft. Thermomechanische Spannungen an der Verbindungsstelle zwischen dem thermoelektrischen Element und den beiden Platten aufgrund unterschiedlicher Wärmeausdehnung der ersten und zweiten Platte, wie sie bei stoffschlüssigen Verbindungen mit der ersten und zweiten Platte auftreten, werden vermieden. Des weiteren lassen sich Materialien mit unterschiedlichem Wärmeausdehnungs-Koeffizient miteinander verbinden.

Um eine gute thermische Ankopplung auf der heißen Seite zu gewährleisten, sind die thermoelektrischen Elemente dort stoffschlüssig mit der ersten Platte verbunden. Zusätzlich kann die Ankopplung auf der heißen Seite auch formschlüssig erfolgen, indem die thermoelektrischen Elemente stirnseitig in entsprechende Formschlusskonturen eingreifen.

Die kraftschlüssige Verbindung zwischen den thermoelektrischen Elementen und jeder Platte erfolgt vorzugsweise mit Hilfe von Klemmen, insbesondere Federklemmen, deren dauerhafte Federeigenschaften den erforderlichen Kraftschluss zwischen jedem thermoelektrischen Element und der Platte erzeugen. Die Klemmen weisen mindestens einen Federabschnitt und einen Befestigungsabschnitt auf, wobei der Befestigungsabschnitt benachbart zu mindest einem thermoelektrischen Element auf der Platte befestigt ist und jeder Federabschnitt an mindestens einem thermoelektrischen Element, vorzugsweise an dessen Seitenflanken, anliegt.

Die Klemmen sind beispielsweise als U- bzw. Winkelprofil ausgestaltet, wobei die freien Schenkel des U-Profils die Federabschnitte und der dazwischen befindliche Bereich den Befestigungsabschnitt bilden. Bei den L-förmigen Profilen dient ein Schenkel als Federabschnitt und einer als Befestigungsabschnitt.

Für die ohnehin erforderliche elektrische Kontaktierung der aus p-und n-Schichten aufgebauten thermoelektrischen Elemente auf der kalten Seite ist es in vorteilhafter Ausgestaltung der Erfindung vorgesehen, dass die Klemmen aus elektrisch leitendem Material bestehen und jedes thermoelektrische Element mindestens zwei Kontaktbereiche auf der kalten Seite aufweist, wobei an jedem Kontaktbereich ein Federabschnitt einer Klemme anliegt.

Um mehrere thermoelektrische Elemente auf einfache Art und Weise parallel und/oder in Reihe zu schalten, sind die Klemmen mit ihren Befestigungsabschnitten an leitfähigen Bereichen, insbesondere Leiterbahnen, auf der Oberfläche der zweiten Platte befestigt.

Als thermoelektrisch aktives Material der thermoelektrischen Elemente kommen insbesondere Legierungen aus Silizium (Si) und Germanium (Ge) in Betracht. Die auf beiden Seiten des Moduls angeordneten Platten bestehen unter Berücksichtigung des Wärmeausdehnungskoeffizienten des thermoelektrisch aktiven Materials vorzugsweise aus keramischem Material, insbesondere Aluminiumnitrid (AlN). Die Aluminiumnitrid-Keramik besitzt eine sehr gute Wärmeleitfähigkeit von 180-220 W/mK. Das Material der Platten ist vorzugsweise elektrisch isolierend, insbesondere um einen unbeabsichtigte elektrische Verbindung zwischen benachbarten thermoelektrischen Elementen durch die Platten zu vermeiden.

Zur stoffschlüssigen Verbindung der thermoelektrischen Elemente mit der ersten Platte kommt vorzugsweise ein Glaslot zum Einsatz. Glaslot ist ein Glas mit besonders niedriger Erweichungstemperatur, das zum thermischen Verbinden von Gegenständen verwendbar ist. Die Erweichungstemperatur des verwendeten Glaslotes liegt vorzugsweise in einem Bereich zwischen 700 ° C - 1000 ° C, in jedem Fall jedoch unterhalb der Erweichungstemperaturen der zu fügenden Materialien der thermoelektrischen Elemente sowie der Platten. Der Ausdehnungs-Koeffizient des Glaslotes wird vorzugsweise durch Zugabe von Füllstoffen, wie beispielsweise Kieselglas, an das Ausdehnungsverhalten der zu verbindenden Materialien angepasst. Durch Temperaturzufuhr schmilzt das Glaslot, während die zu verbindenden Materialien noch fest sind. Insofern ist das Verbindungsverfahren mittels Glaslot dem Löten mit Metallen ähnlich. Da es sich aber um ein NichtMetall handelt, zählen die Glaslote zur Gruppe der Klebstoffe. Die Glaslote lassen sich nicht nur bei sehr hohen Temperaturen verarbeiten, sondern bieten darüber hinaus den Vorteil, dass deren Erweichungstemperatur etwa 200 ° C über den Betriebstemperaturen des Moduls liegen, so dass eine betriebssichere stoffschlüssige Verbindung zwischen jedem thermoelektrischem Element und der ersten Platte auf der heißen Seite dauerhaft gewährleistet ist.

Die thermoelektrischen Elemente bestehen vorzugsweise jeweils aus mindestens einer n-Schicht und mindestens einer p-Schicht aus thermoelektrischem Material unter Ausbildung wenigstens eines sich entlang einer Grenzschicht ausbildenden pn-Übergangs, wobei ein Temperaturgradient parallel zur Grenzschicht zwischen einer heißen und einer kalten Seite jedes derart gebildeten thermoelektrischen Elementes anlegbar bzw. abgreifbar ist.

Eine verbesserte Temperaturverteilung entlang der Grenzschichten zwischen den pn-Übergängen jedes thermoelektrischen Elementes wird dadurch erreicht, dass an den äußeren Schichten parallel zur Grenzschicht des thermoelektrischen Elementes an dessen heißer Seite ein wärmeleitfähiges Material stoffschlüssig befestigt ist. Produktionstechnisch ist es vorteilhaft, wenn das wärmeleitfähige Material mit dem der ersten Platte übereinstimmt und ebenfalls mit Glaslot befestigt wird.

Eine verbesserte thermische Ankopplung des thermoelektrischen Elementes an die kalte Seite wird erreicht, wenn die thermoelektrischen Elemente an ihrer kalten Seite zusätzlich stoffschlüssig mittels eines Klebstoffs, insbesondere auf Polymerbasis, mit der zweiten Platte verbunden sind. Der Klebstoff auf Polymerbasis ist hinreichend elastisch, um einen Ausgleich der thermomechanischen Spannungen zwischen dem thermoelektrischen Element und der zweiten Platte aufgrund der unterschiedlichen Ausdehnungen der beiden Platten zuzulassen.

Sofern die thermoelektrischen Elemente in dem Modul dem Aufbau eines klassischen Peltier-Elementes entsprechen, bei dem insbesondere quaderförmige Blöcke aus p- und n-dotiertem Halbleitermaterial abwechselnd auf der heißen und kalten Seite durch Brücken aus leitendem Material verbunden sind, ist es zweckmäßig, dass die thermoelektrischen Elemente nicht nur an der kalten Seite, sondern auch ihrer heißen Seite kraftschlüssig, insbesondere mit Hilfe von Klemmen mit der ersten Platte verbunden sind. Entsprechend dem klassischen Aufbau wechseln sich sowohl auf der heißen als auch der kalten Seite, allerdings versetzt zueinander, elektrisch leitende und elektrisch nicht leitende Klemmen ab, um die einzelnen Blöcke elektrisch miteinander zu verbinden. Die elektrisch leitenden Klemmen bilden dann die Brücken aus leitendem Material.

Ein vorteilhaftes Verfahren zur Herstellung eines erfindungsgemäßen Moduls ergibt sich aus den nachfolgend erläuterten Merkmalen des Anspruchs 12:
- Zunächst wird das Modul an der heißen Seite des thermoelektrischen Elementes vorbereitet, indem vorzugsweise auf die erste Platte Klebstoff, insbesondere eine Glaslotpaste, aufgetragen wird. In die Paste aus Glaslot werden die Stirnflächen der thermoelektrischen Elemente hineingedrückt.
- Sodann werden die erste Platte und die thermoelektrischen Elemente zeitweilig auf die Erweichungstemperatur des Klebstoffs (Glaslotes) erhitzt. Die Erhitzung kann beispielsweise in einem Ofen erfolgen.
- Anschließend wird die kalte Seite des Moduls fertig gestellt, indem die thermoelektrischen Elemente mit ihrer kalten Seite zwischen die Federabschnitte von mindestens zwei im Abstand zueinander auf der zweiten Platte angeordneten Klemmen geschoben werden, so dass die Kontaktbereiche des thermoelektrischen Elementes an den Federabschnitten der Klemmen anliegen. Zuvor müssen an den leitenden Bereichen der zweiten Platte die Klemmen mit deren Befestigungsabschnitt befestigt werden.

Um ein Modul nach Anspruch 8 herzustellen, werden vor dem Erhitzen der ersten Platte mit den thermoelektrischen Elementen auf das wärmeleitfähige Material und/oder die Seitenflanken des thermoelektrischen Elementes ein Klebstoff, insbesondere Glaslot, aufgebracht und anschließend die Seitenflanken und das wärmeleitfähige Material gegeneinander gedrückt.

Um die elektrischen Verbindungen zwischen den thermoelektrischen Elementen des Moduls und den elektrisch leitenden Federabschnitten der Klemmen störungssicher und preiswert herzustellen, wird in einer Ausgestaltung des erfindungsgemäßen Herstellungsverfahrens vorgeschlagen, dass auf die dem thermoelektrischen Element zugewandte Oberfläche der Federabschnitte und/oder die Kontaktbereiche des thermoelektrischen Elementes ein Metalllot aufgebracht wird und anschließend zumindest die Kontaktbereiche und/oder die Federabschnitte zeitweilig erhitzt werden, um das Metalllot aufzuschmelzen.

Nachfolgend wird die Erfindung anhand der Figuren näher erläutert. Es zeigen:

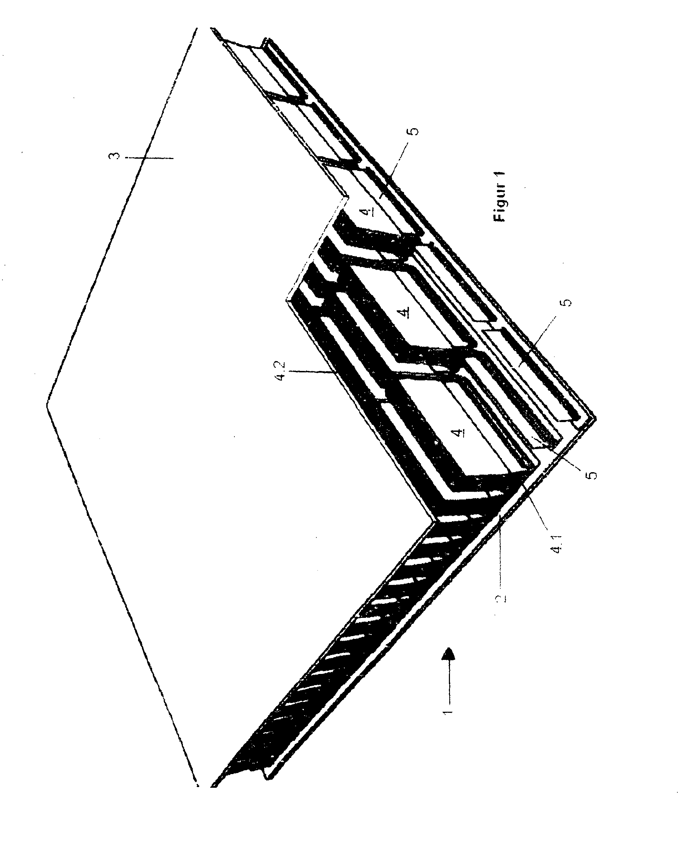

- **Figur 1**: eine perspektivische Ansicht eines erfindungsgemäßen Moduls, teilweise aufgeschnitten,
- **Figur 2**: eine Detaildarstellung eines thermoelektrischen Elementes eines Moduls nach Figur 1,
- **Figur 3**: eine schematische Schnittdarstellung einer ersten Ausführungsform des thermoelektrischen Moduls,
- **Figur 4**: eine schematische Schnittdarstellung einer zweiten Ausführungsform des erfindungsgemäßen Moduls,
- **Figur 5 a**: eine schematische Aufsicht auf die Unterseite einer zweiten Platte auf der kalten Seite des Moduls,

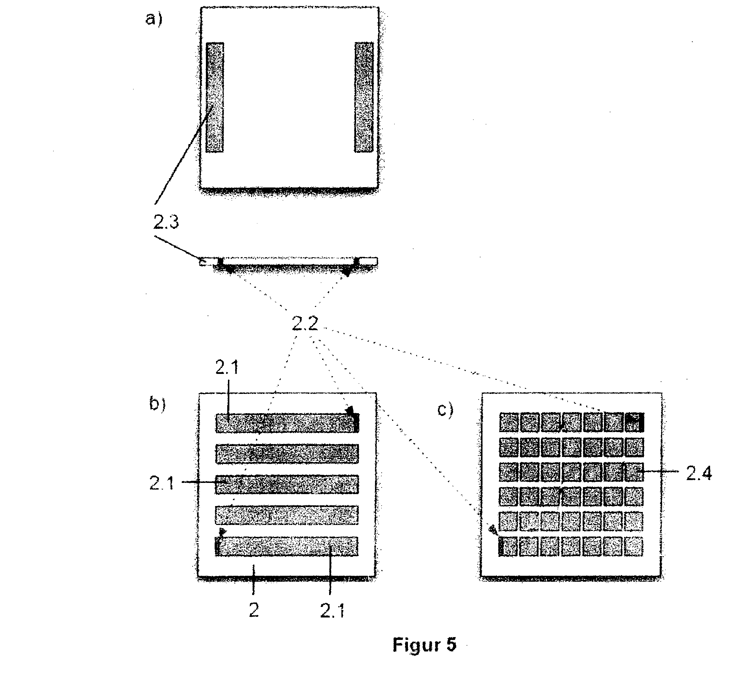

- **Figur 5 b**: eine schematische Aufsicht auf die Oberseite einer zweiten Platte an der kalten Seite des Moduls,
- **Figur 5 c**: eine schematische Aufsicht auf die Oberseite einer zweiten Platte an der kalten Seite des Moduls in modifizierter Ausführungsform,

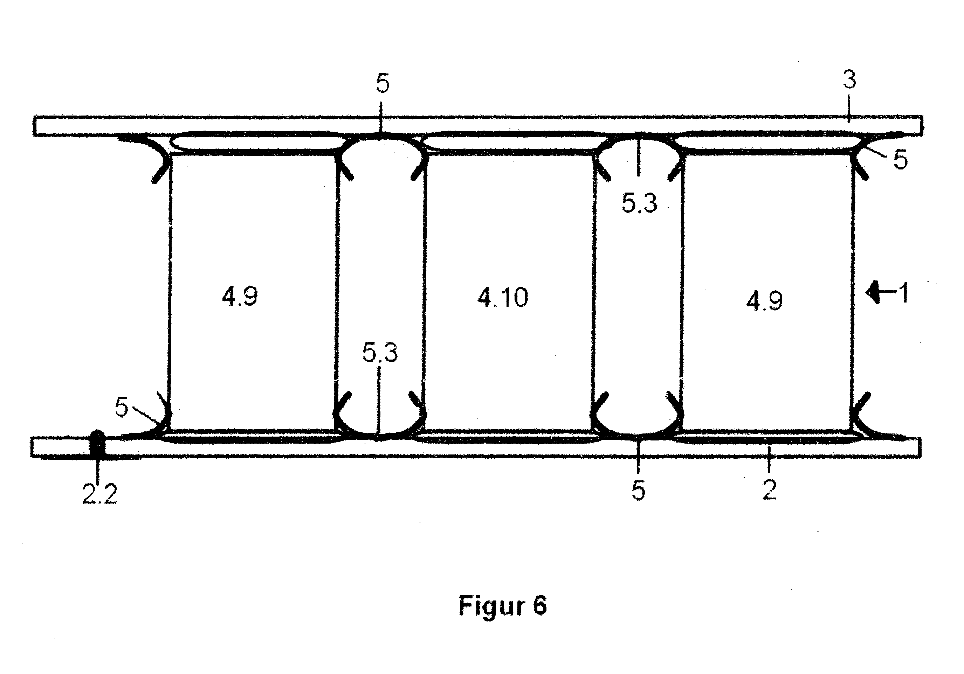

- **Figur 6**: eine schematische Seitenansicht eines erfindungsgemäßen Moduls mit herkömmlichen thermoelektrischen Elementen sowie

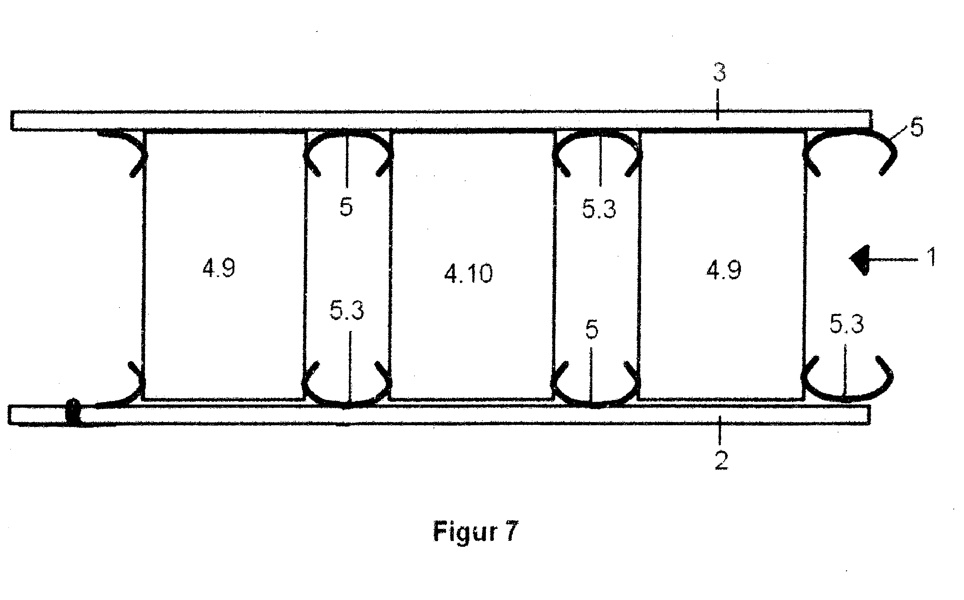

- **Figur 7**: eine weitere schematische Ansicht eines erfindungsgemäßen Moduls mit herkömmlichen thermoelektrischen Elementen.

Das erfindungsgemäße Modul (1) umfasst eine zweite keramische Platte (2) auf der kalten Seite und eine im Abstand dazu angeordnete erste keramische Platte (3) auf der heißen Seite. Zwischen den Platten (2, 3) sind eine Vielzahl thermoelektrischer Elemente (4) angeordnet, die mit ihrer Stirnseite (4.1) an der zweiten Platte (2) und ihrer Stirnseite (4.2) an der ersten Platte (3) anliegen.

Sämtliche thermoelektrischen Elemente (4) sind an ihrer kalten Seite kraftschlüssig mit Hilfe von Klemmen (5) mit der zweiten Platte (2) verbunden. Die kraftschlüssige Verbindung wirkt tangential zu den Seitenflanken jedes thermoelektrischen Elementes.

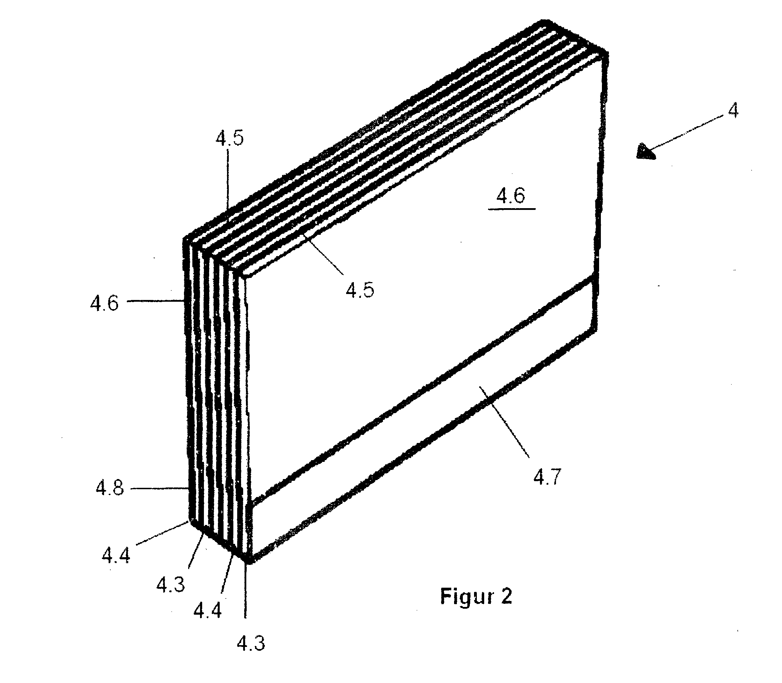

Das im Detail in Figur 2 dargestellte blockförmige thermoelektrische Element (4) besteht aus einem Schichtpaket mit drei n-Schichten (4.3) und drei p-Schichten (4.4) aus thermoelektrischem Material, insbesondere Siliziumgermanium (SiGe), wobei sich entlang der Grenzschichten pn-Übergänge (4.5) ausbilden. Parallel zu der Grenzschicht ist ein Temperaturgradient zwischen der heißen Seite an der ersten Platte (3) und der kalten Seite an der Platte (2) anlegbar.

An den nach außen weisenden Seitenflanken (4.6) besitzt jedes thermoelektrische Element (4) zwei Kontaktbereiche (4.7, 4.8) zur elektrischen Kontaktierung der Halbleiter des thermoelektrischen Elementes (4). Die Kontaktbereiche sind als horizontaler Streifen am unteren Rand des thermoelektrischen Elementes (4) an dessen kalter Seite, das heißt unmittelbar angrenzend an die keramische zweite Platte (2) angeordnet.

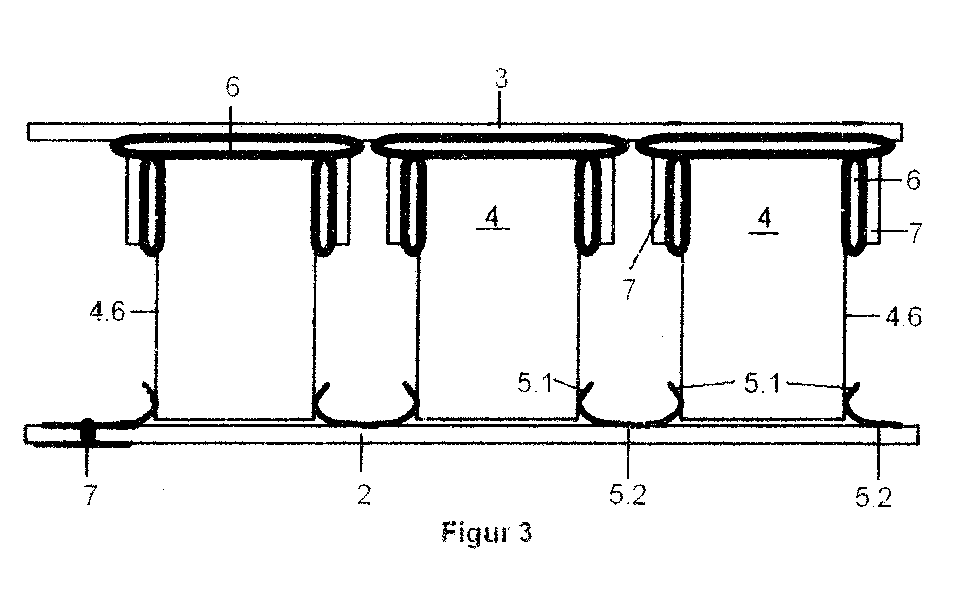

Die aus Figur 3 erkennbare Anbindung der thermoelektrischen Elemente (4) an der keramischen Platte (2) auf der kalten Seite erfolgt mit den Klemmen (5), die an den Kontaktbereichen (4.7, 4.8) der beiden Seitenflanken (4.6) anliegen. Die am äußeren Rand des der zweiten Platte (2) des Moduls (1) angeordneten Klemmen (5) sind im wesentlichen L-förmig profiliert und weisen einen Federabschnitt (5.1)und einen Befestigungsabschnitt (5.2) auf, der benachbart zu den äußeren thermoelektrischen Elementen (4) auf der Platte (2) befestigt ist. Die übrigen Klemmen (5), die jeweils zwischen zwei benachbarten thermoelektrischen Elementen (4) angeordnet sind, weisen jeweils zwei Federabschnitte (5.1) und einen mittig zwischen den Federabschnitten (5.1) angeordneten Befestigungsabschnitt (5.2) auf. Die Federabschnitte (5.1) der Klemmen (5) liegen an den Kontaktbereichen (4.7, 4.8) der thermoelektrischen Elemente (4) an.

Die Klemmen (5) sind auf Leiterbahnen (2.1) an der keramischen Platte (2) auf der kalten Seite befestigt. Figur 5b veranschaulicht die Anordnung der Leiterbahnen (2.1), wobei die thermoelektrischen Elemente (4) zeilenförmig entlang jeder Leiterbahn (2.1) elektrisch parallel zueinander geschaltet sind und die in unterschiedlichen Zeilen angeordneten thermoelektrischen Elemente (4) elektrisch in Serie geschaltet sind. Die elektrische Kontaktierung des gesamten Moduls erfolgt mittels einer Durchkontaktierung (2.2) an den beiden äußeren Leiterbahnen (2.1) zu einem elektrischen Kontakt (2.3) auf der nach außen weisenden Seite der keramischen Platte (2) (vgl. Figur 5 a)).

Figur 5 c) zeigt eine Anordnung der Kontaktbereiche (2.4), die eine Reihenschaltung sämtlicher thermoelektrischer Elemente (4) erlaubt, um eine möglichst hohe Ausgangsspannung des Moduls (1) zu erzielen.

In dem Ausführungsbeispiel nach Figur 3 bestehen die Klemmen (5) aus elektrisch leitendem Material und sind an den Leiterbahnen (2.1) bzw. Kontaktbereichen (2.4) der keramischen Platte (2) befestigt. Insofern dienen die Kontakte nicht nur der kraftschlüssigen Verbindungen der thermoelektrischen Elemente (4) mit der Platte (2), sondern darüber hinaus deren notwendiger elektrischer Kontaktierung.

Die thermoelektrischen Elemente (4) werden auf der kalten Seite ausschließlich durch die Tangentialkräfte zwischen den Federabschnitten (5.1) der Klemmen (5) und den Seitenflanken (4.6) der thermoelektrischen Elemente (4) gehalten, die aufgrund der federelastischen Eigenschaften der Federabschnitte (5.1) hervorgerufen werden. Zum Einschieben der Stirnseiten der thermoelektrischen Elemente (4) zwischen zwei benachbart angeordnete Klemmen (5) muss diese tangential wirkende Kraft zeitweilig überschritten werden. Um ein leichtes Einfädeln der thermoelektrischen Elemente (4) zwischen zwei benachbarte Klemmen zu ermöglichen, sind die Enden der Federabschnitte (5.1) vorzugsweise nach innen gebogen ausgeführt.

Die thermoelektrischen Elemente (4) sind an der heißen Seite mittels eines Glaslotes (6) an der Platte (3) befestigt. Das zur Gruppe der Klebstoffe gehörende Glaslot (6) erzeugt eine stoffschlüssige Verbindung, die im Ausdehnungsverhalten an die keramische Platte (3) angepasst ist. Zusätzlich ist auf der heißen Seite jedes thermoelektrischen Elementes an den Seitenflanken (4.6) ein wärmeleitfähiges Material (7) stoffschlüssig mittels Glaslot (6) befestigt. Das wärmeleitfähige Material (7) entspricht vorzugsweise dem Material der keramischen Platte (3). In Betracht kommt insbesondere eine hoch wärmeleitende Aluminiumnitrid-Keramik. Das auf der heißen Seite angeordnete wärmeleitfähige Material (7) verbessert die Temperaturverteilung in dem thermoelektrischen Element (4).

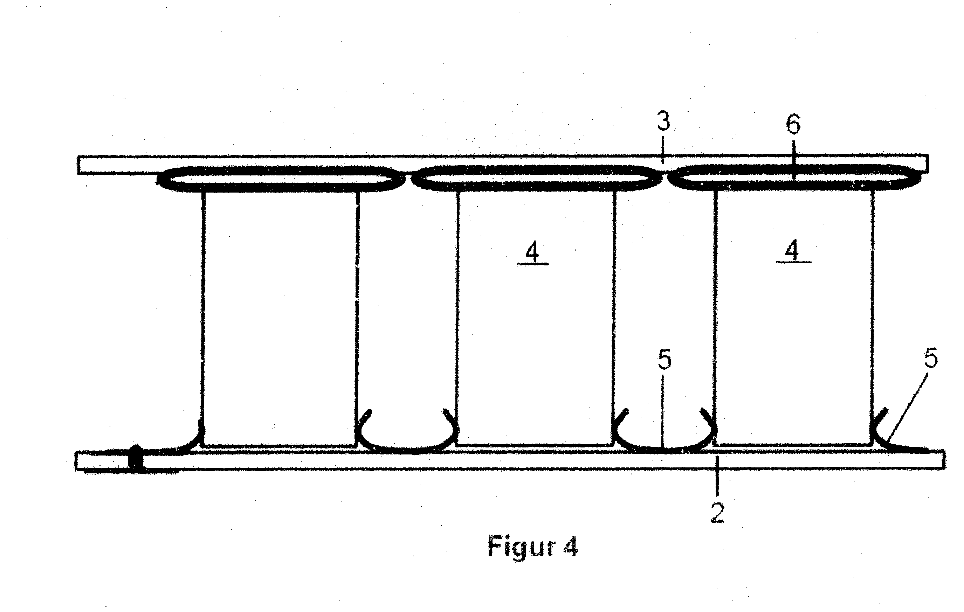

Das Ausführungsbeispiel nach Figur 4 unterscheidet sich von dem Ausführungsbeispiel nach Figur 3 lediglich dadurch, dass auf das zusätzliche wärmeleitfähige Material (7) an den Seitenflanken (4.6) der thermoelektrischen Elemente (4) verzichtet wurde.

Figuren 6 und 7 zeigen jeweils ein Modul (1), dessen thermoelektrische Elemente (4) dem Aufbau eines klassischen Peltier-Elementes entsprechen, bei dem quaderförmige Blöcke (4.9, 4.10) aus p- und n-dotiertem Halbleitermaterial abwechselnd auf der heißen und kalten Seite durch leitendes Material verbunden sind. Die Blöcke (4.9, 4.10) der thermoelektrischen Elemente (4) sind nicht nur an der kalten Seite, sondern auch ihrer heißen Seite kraftschlüssig mit Hilfe von Klemmen (5) mit der ersten bzw. zweiten Platte (2,3) verbunden. Entsprechend dem klassischen Aufbau wechseln sich sowohl auf der heißen als auch der kalten Seite, allerdings versetzt zueinander, elektrisch leitende Klemmen (5) und elektrisch nicht leitende Klemmen (5.3) ab.

Die Blöcke (4.9, 4.10) sind in dem Ausführungsbeispiel an beiden Stirnseiten zusätzlich mittels eines Klebstoffs an die Keramikplatte (2, 3) angebunden. In Betracht kommt auf der heißen Seite insbesondere ein Glaslot (6) mit angepasstem Ausdehnungskoeffizienten und auf der kalten Seite ein Klebstoff auf Polymerbasis. Die bei herkömmlichen Peltier-Elementen üblicherweise abwechselnd an der oberen bzw. unteren Stirnseite angebrachten Metallbrücken werden durch die elektrisch leitfähigen Klemmen (5) ersetzt, über die die thermoelektrischen Elemente (4) miteinander verbunden sind. Die Ausführungsform nach Figur 6 kommt insbesondere dann in Betracht, wenn das Modul (1) mit relativ geringen Temperaturdifferenzen zwischen heißer und kalter Seite betrieben wird.

Bei höheren Temperaturdifferenzen wird vorzugsweise sowohl auf der heißen als auch der kalten Seite, wie in Figur 7 dargestellt, auf die zusätzliche stoffschlüssige Verbindung mittels eines Klebstoffs verzichtet. In dem Ausführungsbeispiel nach Figur 7 werden die thermoelektrischen Blöcke (4.9, 4.10) der thermoelektrischen Elemente (4) ausschließlich kraftschlüssig mit Hilfe von Klemmen (5, 5.3) an beiden keramischen Platten (2, 3) gehalten.

**Bezugszeichenliste**

| **Nr.** | **Bezeichnung** |
|---|---|
| 1 | Modul |
| 2 | keramische Platte (kalt) |
| 2.1 | Leiterbahnen |
| 2.2 | Durchkontaktierung |
| 2.3 | Kontakt |
| 2.4 | Kontaktbereich |
| 3 | keramische Platte (heiß) |
| 4 | thermoelektrisches Element |
| 4.1 | Stirnseite (kalt) |
| 4.2 | Stirnseite (heiß) |
| 4.3 | n-Schicht |
| 4.4 | p-Schicht |
| 4.5 | pn-Übergang |
| 4.6 | Seitenflanke |
| 4.7 | Kontaktbereich |
| 4.8 | Kontaktbereich |
| 4.9 | Blöcke |
| 4.10 | Blöcke |
| 5 | Klemme |
| 5.1 | Federabschnitt |
| 5.2 | Befestigungsabschnitt |
| 5.3 | elektrisch nicht leitende Klemme |
| 6 | Glaslot |
| 7 | wärmeleitfähiges Material |

## Patentansprüche

1. Modul (1) umfassend mehrere elektrisch verbundene thermoelektrische Elemente (4), die zwischen einer ersten und einer zweiten Platte (2, 3) angeordnet sind, wobei ein Temperaturgradient zwischen einer heißen und einer kalten Seite jedes thermoelektrischen Elementes anlegbar bzw. abgreifbar ist und die thermoelektrischen Elemente (4) an ihrer heißen Seite an der ersten Platte (3) und an ihrer kalten Seite an der zweiten Platte (2) anliegen, **dadurch gekennzeichnet, dass**
- die thermoelektrischen Elemente (4) an ihrer kalten Seite kraftschlüssig mit der zweiten Platte (2) verbunden sind und
- die thermoelektrischen Elemente (4) an ihrer heißen Seite stoffschlüssig mit der ersten Platte (3) verbunden sind.

2. Modul nach Anspruch 1, **dadurch gekennzeichnet, dass** die thermoelektrischen Elemente (4) an ihrer heißen Seite zusätzlich kraftschlüssig mit der ersten Platte (3) verbunden sind.

3. Modul nach Anspruch 1 oder 2, **dadurch gekennzeichnet, dass** die thermoelektrischen Elemente (4) mit Hilfe von Klemmen (5) kraftschlüssig mit der zweiten Platte (2) und gegebenenfalls der ersten Platte (3) verbunden sind.

4. Modul nach Anspruch 3, **dadurch gekennzeichnet, dass** jede Klemme (5) mindestens einen Federabschnitt (5.1) und einen Befestigungsabschnitt (5.2) aufweist, wobei der Befestigungsabschnitt (5.2) benachbart zu mindestens einem thermoelektrischen Element (4) auf der zweiten Platte (2) und gegebenenfalls der ersten Platte (3) befestigt ist und jeder Federabschnitt (5.2) an mindestens einem thermoelektrischen Element (4) anliegt.

5. Modul nach Anspruch 4, **dadurch gekennzeichnet, dass** die Klemmen (5) aus elektrisch leitendem Material bestehen, dass jedes thermoelektrische Element (4) mindestens zwei Kontaktbereiche (4.7, 4.8) auf der kalten Seite aufweist und an jedem Kontaktbereich der Federabschnitt (5.1) einer Klemme aus elektrisch leitendem Material anliegt.

6. Modul nach Anspruch 4 oder 5, **dadurch gekennzeichnet, dass** an leitfähigen Bereichen (2.1, 2.4) auf der Oberfläche der zweiten Platte (2) die Befestigungsabschnitte (5.2) der Klemmen befestigt sind.

7. Modul nach einem der Ansprüche 2 bis 6, **dadurch gekennzeichnet, dass** die thermoelektrischen Elemente (4) an ihrer heißen Seite stoffschlüssig mittels eines Glaslotes (6) mit der ersten Platte (3) verbunden sind.

8. Modul nach einem der Ansprüche 2 bis 7, **dadurch gekennzeichnet, dass** an Seitenflanken (4.6) des thermoelektrischen Elementes an dessen heißer Seite ein wärmeleitfähiges Material (7) stoffschlüssig befestigt ist.

9. Modul nach Anspruch 8, **dadurch gekennzeichnet, dass** das wärmeleitfähige Material (7) mittels eines Glaslotes (6) befestigt ist.

10. Modul nach einem der Ansprüche 1 - 9, **dadurch gekennzeichnet, dass** die thermoelektrischen Elemente (4) an ihrer kalten Seite zusätzlich stoffschlüssig mittels eines Klebstoffs, insbesondere auf Polymerbasis, mit der zweiten Platte (2) verbunden sind.

11. Modul nach einem der Ansprüche 1 - 10, **dadurch gekennzeichnet, dass** die thermoelektrischen Elemente jeweils aus mindestens einer n-Schicht und mindestens einer p-Schicht aus thermoelektrischem Material unter Ausbildung wenigstens eines sich entlang einer Grenzschicht ausbildenden pn-Übergangs bestehen, wobei der Temperaturgradient parallel zur Grenzschicht zwischen der heißen und der kalten Seite jedes thermoelektrischen Elementes anlegbar bzw. abgreifbar ist.

12. Verfahren zur Herstellung eines Moduls nach den Ansprüchen 1, 2, 3, 4 und 5, **dadurch gekennzeichnet, dass**
- auf die erste Platte (3) und /oder auf die Stirnfläche (4.2) jedes thermoelektrischen Elementes (4) an der heißen Seite ein Klebstoff (6) aufgetragen wird,
- die erste Platte (3) und jedes thermoelektrische Element (4) gegeneinander gedrückt werden,
- die erste Platte (3) und jedes thermoelektrische Element (4) zeitweilig wenigstens auf die Erweichungstemperatur des Klebstoffs (6) erhitzt werden,
- an den leitenden Bereichen (2.1, 2.4) der zweiten Platte (2) Klemmen (5) mit ihrem Befestigungsabschnitt (5.2) befestigt werden und
- schließlich die thermoelektrischen Elemente (4) mit ihrer kalten Seite zwischen die Federabschnitte (5.1) von mindestens zwei im Abstand zueinander angeordneten Klemmen (5) geschoben werden, so dass die Kontaktbereiche (4.7, 4.8) des thermoelektrischen Elementes (4) an den Federabschnitten (5.1) der Klemmen (5) anliegen.

13. Verfahren nach Anspruch 12 zur Herstellung eines Moduls nach den Ansprüchen 1, 2, 3, 4, 5 und Anspruch 8, **dadurch gekennzeichnet, dass** vor dem Erhitzen auf das wärmeleitfähige Material (7) und /oder die Seitenflanken (4.6) des thermoelektrischen Elementes (4) ein Klebstoff (6) aufgebracht wird und die Seitenflanken (4.6) und das wärmeleitfähige Material (7) gegeneinander gedrückt werden.

14. Verfahren nach Anspruch 12 oder 13, **dadurch gekennzeichnet, dass** auf die dem thermoelektrischen Element (4) zugewandte Oberfläche der Federabschnitte (5.1) und/oder die Kontaktbereiche (4.7, 4.8) des thermoelektrischen Elementes (4) ein Metalllot aufgebracht wird und anschließend zumindest die Kontaktbereiche und/oder die Federabschnitte zeitweilig erhitzt werden, um das Metalllot aufzuschmelzen.

## Claims

1. A module (1) comprising a plurality of electrically connected thermoelectric elements (4) which are disposed between a first and a second plate (2, 3), wherein a temperature gradient can be applied or tapped off between a hot and a cold side of each thermoelectric element and the thermoelectric elements (4) rest with their hot side on the first plate (3) and with their cold side on the second plate (2) **characterized in that**
- the thermoelectric elements (4) are connected on their cold side non-positively to the second plate (2) and
- the thermoelectric elements (4) are connected on their hot side in a material bonded manner to the first plate (3).

2. The module according to claim 1, **characterized in that** the thermoelectric elements (4) are additionally connected on their hot side non-positively to the first plate (3).

3. The module according to claim 1 or 2, **characterized in that** the thermoelectric elements (4) are connected with the aid of clamps (5) non-positively to the second plate (2) and optionally to the first plate (3).

4. The module according to claim 3, **characterized in that** each clamp (5) has at least one spring section (5.1) and a fastening section (5.2), wherein the fastening section (5.2) is connected adjacent to at least one thermoelectric element (4) on the second plate (2) and optionally the first plate (3) and each spring section (5.2) rests on at least one thermoelectric element (4).

5. The module according to claim 4, **characterized in that** the clamps (5) consist of electrically conductive material, that each thermoelectric element (4) has at least two contact regions (4.7, 4.8) on the cold side and the spring section (5.1) of one clamp made of electrically conductive material rests on each contact region.

6. The module according to claim 4 or 5, **characterized in that** the fastening sections (5.2) of the clamps are fastened to conductive regions (2.1, 2.4) on the surface of the second plate (2).

7. The module according to any one of claims 2 to 6, **characterized in that** the thermoelectric elements (4) are connected on their hot side to the first plate (3) in a material bonded manner by means of a glass solder (6).

8. The module according to any one of claims 2 to 7, **characterized in that** a heat-conductive material (7) is fastened in a material bonded manner to side flanks (4.6) of the thermoelectric element on its hot side.

9. The module according to claim 8, **characterized in that** the heat-conductive material (7) is fastened by means of a glass solder (6).

10. The module according to any one of claims 1-9, **characterized in that** the thermoelectric elements (4) are additionally connected on their cold side to the second plate (2) in a material bonded manner by means of an adhesive, in particular polymer-based.

11. The module according to any one of claims 1-10, **characterized in that** the thermoelectric elements each consist of at least one n-layer and at least one player of thermoelectric material to form at least one pn-junction formed along a boundary layer, wherein the temperature gradient can be applied or tapped off parallel to the boundary layer between the hot and the cold side of each thermoelectric element.

12. A method for manufacturing a module according to claims 1, 2, 3, 4 and 5, **characterized in that**
- an adhesive (6) is applied to the first plate (3) and/or to the front face (4.2) of each thermoelectric element (4) on the hot side,
- the first plate (3) and each thermoelectric element (4) are pressed towards one another,
- the first plate (3) and each thermoelectric element (4) are temporarily heated at least to the softening temperature of the adhesive (6),
- clamps (5) are fastened with their fastening section (5.2) onto the conductive regions (2.1, 2.4) of the second plate (2) and
- finally the thermoelectric elements (4) are pushed with their cold side between the spring sections (5.1) of at least two clamps (5) disposed at a distance from one another so that the contact regions (4.7, 4.8) of the thermoelectric element (4) rest on the spring sections (5.1) of the clamps (5).

13. The method according to claim 12 for producing a module according to claims 1, 2, 3, 4, 5 and claim 8, **characterized in that** before heating an adhesive (6) is applied to the heat-conductive material (7) and/or the side flanks (4.6) of the thermoelectric element (4) and the side flanks (4.6) and the heat-conductive material (7) are pressed towards one another.

14. The method according to claim 12 or 13, **characterized in that** a metal solder is applied to the surface of the spring sections (5.1) facing the thermoelectric element (4) and/or the contact regions (4.7, 4.8) of the thermoelectric element (4) and then at least the contact regions and/or the spring sections are temporarily heated in order to melt the metal solder.

## Revendications

1. Module (1) comprenant plusieurs éléments (4) thermoélectriques électriquement reliés qui sont placés entre une première et une deuxième plaque (2, 3), un gradient thermique pouvant être appliqué ou prélevé entre un côté chaud et un côté froid de chaque élément thermoélectrique et les éléments (4) thermoélectriques étant adjacents par leur côté chaud à la première plaque (3) et par leur côté froid à la deuxième plaque (2), **caractérisé en ce que**
- sur leur côté froid, les éléments (4) thermoélectriques sont reliés par complémentarité de force avec la deuxième plaque (2) et
- sur leur côté chaud, les éléments (4) thermoélectriques sont reliés par matière avec la première plaque (3).

2. Module selon la revendication 1, **caractérisé en ce que** sur leur côté chaud, les éléments (4) thermoélectriques sont en supplément reliés par complémentarité de force avec la première plaque (3).

3. Module selon la revendication 1 ou la revendication 2, **caractérisé en ce que** les éléments (4) thermoélectriques sont reliés par complémentarité de force à l'aide de barrettes (5) avec la deuxième plaque (2) et le cas échéant avec la première plaque (3).

4. Module selon la revendication 3, **caractérisé en ce que** chaque barrette (5) comporte au moins une partie à ressort (5.1) et une partie de fixation (5.2), au voisinage d'au moins un élément (4) thermoélectrique, la partie de fixation (5.2) étant fixée sur la deuxième plaque (2) et le cas échéant sur la première plaque (3) et chaque partie à ressort (5.2) étant adjacente à au moins un élément (4) thermoélectrique.

5. Module selon la revendication 4, **caractérisé en ce que** les barrettes (5) sont constituées d'une matière conductrice d'électricité, **en ce que** chaque élément (4) thermoélectrique comporte au moins deux zones de contact (4.7, 4.8) sur le côté froid et la partie à ressort (5.1) d'une barrette en matière conductrice d'électricité étant adjacente à chaque zone de contact.

6. Module selon la revendication 4 ou la revendication 5, **caractérisé en ce que** sur des zones (2.1, 2.4) conductrices sur surface de la deuxième plaque (2) sont fixées les parties de fixation (5.2) des barrettes.

7. Module selon l'une quelconque des revendications 2 à 6, **caractérisé en ce que** sur leur côté chaud, les éléments (4) thermoélectriques sont reliés par matière avec la première plaque (3) au moyen d'un verre de soudure (6).

8. Module selon l'une quelconque des revendications 2 à 7, **caractérisé en ce que** sur des flancs latéraux (4.6) de l'élément thermoélectrique, sur son côté chaud, une matière (7) conductrice thermique est fixée par matière.

9. Module selon la revendication 8, **caractérisé en ce que** la matière (7) conductrice thermique est fixée au moyen d'un verre de soudure (6).

10. Module selon l'une quelconque des revendications 1 à 9, **caractérisé en ce que** sur leur côté froid, les éléments (4) thermoélectriques sont reliés également avec la deuxième plaque (2) au moyen d'un agent adhésif, notamment sur base polymère.

11. Module selon l'une quelconque des revendications 1 à 10, **caractérisé en ce que** les éléments thermoélectriques sont constitués chacun d'au moins une couche n et d'au moins une couche p en matière thermoélectrique, en formant au moins un passage pn se formant le long d'une couche limitrophe, le gradient thermique pouvant être appliqué ou prélevé à la parallèle de la couche limitrophe, entre le côté chaud et le côté froid de chaque élément thermoélectrique.

12. Procédé de production d'un module selon les revendications 1, 2, 3, 4 et 5, **caractérisé en ce que**
- sur la première plaque (3) et/ou sur la face frontale (4.2) de chaque élément (4) thermoélectrique, on applique sur le côté chaud un agent adhésif (6),
- on appuie l'un contre l'autre la première plaque (3) et chaque élément (4) thermoélectrique,
- on chauffe momentanément la première plaque (3) et chaque élément (4) thermoélectrique à la température de ramollissement de l'agent adhésif (6),
- sur les zone conductrices (2.1, 2.4) de la deuxième plaque (2), on fixe des barrettes (5) par leur partie de fixation (5.2) et
- pour finir, on pousse les éléments (4) thermoélectriques par leur côté froid entre les parties à ressort (5.1) d'au moins deux barrettes (5) placées avec un écart mutuel, de sorte que les zones de contact (4.7, 4.8) de l'élément (4) thermoélectrique soient adjacentes aux parties à ressort (5.1) des barrettes (5).

13. Procédé selon la revendication 12 pour la production d'un module selon les revendications 1, 2, 3 ,4, 5 et la revendication 8, **caractérisé en ce qu'**avant l'échauffement, on applique sur la matière (7) conductrice thermique et/ou sur les flancs latéraux (4.6) de l'élément (4) thermoélectrique un agent adhésif (6) et on appuie l'un contre l'autre les flancs latéraux (4.6) et la matière (7) conductrice thermique.

14. Procédé selon la revendication 12 ou la revendication 13, **caractérisé en ce que** sur la surface des parties à ressort (5.1) qui est dirigée vers l'élément (4) thermoélectrique et/ou sur les zones de contact (4.7, 4.8) de l'élément (4) thermoélectrique, on applique un verre de soudure et par la suite, on chauffe momentanément au moins les zones de contact et/ou les parties à ressort, pour faire fondre le verre de soudure.
